# EUROPEAN PATENT SPECIFICATION

(11) **EP 3 460 576 B1**
(45) Date of publication and mention of the grant of the patent: **01.04.2020**
(21) Application number: 18196296.0
(22) Date of filing: 24.09.2018
(51) Int. Cl.: G03F 7/24, G03F 7/30

(54) **TREATMENT ASSEMBLY OF THE WATER-BASED LIQUID USED IN A WASHING STATION FOR FLEXOGRAPHIC PLATES**
BEHANDLUNGSANORDNUNG DER IN EINER WASCHSTATION FÜR FLEXODRUCKPLATTEN VERWENDETEN WASSERBASIERTEN FLÜSSIGKEIT
ENSEMBLE DE TRAITEMENT DE LIQUIDE À BASE D'EAU UTILISÉ DANS UNE STATION DE LAVAGE DE PLAQUES FLEXOGRAPHIQUES

(30) Priority: 22.09.2017 EP 17192575
(43) Date of publication of application: 27.03.2019
(73) Proprietor: SASU VIANORD ENGINEERING, 06510 Carros (FR)
(72) Inventor: DE CARIA, Riccardo, 20080 BASIGLIO (IT)
(74) Representative: De Bortoli, Tiziano

(56) References cited:
- EP-A1- 0 624 828
- EP-A1- 1 406 125
- CN-A- 105 130 032
- US-A- 5 828 923

## Description

### FIELD OF THE INVENTION

The present invention relates to the field of processes for preparing analog and/or digital printing plates for flexography. In particular, the present invention relates to a washing station comprising an assembly for treating and recovering the water used for washing a flexographic plate.

### PRIOR ART

Flexography is a direct rotary printing method which employs plates in relief made of photo-polymeric materials. The plates are flexible and soft, hence the name flexography. Such plates are inked and the print is obtained by means of direct deposition of the ink on the medium to be printed by virtue of a slight pressure exerted by a printing cylinder on which the plates are positioned.

Flexography is a high-speed printing process, capable of printing on many types of absorbing and non-absorbing materials. Some typical applications of flexographic printing are the making of paper and plastic bags, milk cartons, disposable cups and the like, but by virtue of the progress in printing quality, flexography is today also used for printing newspapers, for example, as well as packets and labels and for printing on plastic, films and acetate sheets, packing paper and on many other materials used for product packaging.

*"Digital flexography"* is a particular process of flexographic printing in which digital plates are used. In such plates, the photo-polymer is originally covered by a surface layer of material which prevents photo-exposure, such as for example a carbon or graphite layer. Such layer of material is etched so as to create the negative image of the print subject. Such step of etching is usually performed by means of a digital laser, controlled by a computer (hence the acronym CTP *"Computer To Plate"* used to indicate this step of the pre-printing process in the sector). The plate is then photo-exposed and the material not exposed to the light is eliminated by means of a washing operation performed at a washing station.

In particular, the plate is typically washed using solvent-based liquid which dissolves the monomer (or polymer). Alternatively, the washing liquid may be water-based. In all cases, the mechanical action of brushes, which act on the plate surface to promote the detachment of the monomer (or polymer) previously not exposed to light, is provided. In particular, in the case of washing with water-based liquid, a stronger mechanical action is required from the brushes because the water alone cannot dissolve the monomer or polymer, but only soften it.

In both cases, after a given number of processed plates, the washing liquid must be treated in order to recover the monomer (or polymer), separating it from the solvent base or from the water base.

For the solvent-based washing of the plates, the use of solvent-based liquid has been proven to be effective but regretfully accompanied by several drawbacks, the first of which relates to the release of volatile organic compounds (VOC). As known, these compounds are accompanied by a high degree of toxicity and their concentration must be constantly monitored so that the values are kept within the limits established by law.

Another drawback related to the use of solvent-base liquids is that the final user of the plates, i.e. the printer, is forced to outsource plate preparation. This to avoid accumulating large amounts of solvent in environments adjacent to printing zones. So, digital printing plates are nearly ever sold directly to printers, but instead are sold to companies which are involved only with preparing them. This aspect obviously translates into less profit for plate manufacturers.

Yet another drawback is related to the disposal of the solvent, which is very complicated in terms of environmental safety.

Given the disadvantages presented above, the use of a water-based liquid for washing flexographic plates is certainly preferable to the use of solvent-based liquid. Water is indeed much easier to manage and does not imply the release of volatile organic compounds.

However, it has been found that the use of water-based washing liquid is not very widespread due to the difficulties currently encountered in treating the liquid for separating the monomer (or polymer) part from the water part. Such treatment become necessary when the concentration of monomer (or polymer) exceeds a threshold, making the washing liquid ineffective for the purpose.

Normally, water-based liquid is treated according to two methods, the first of which includes the use of filters, which mechanically separate the monomer (or polymer) from the liquid part. Such filters however must be cleaned very frequently and this inevitably influences the downtime, and thus the productivity, of the washing station.

Alternatively, after having washed a given number of plates, the used liquid is replaced with other liquid. The used liquid is transferred to a treatment station, in which the monomer (or polymer) is separated from the water by means of a distillation process. Such process includes the evaporation and the successive condensation of the water which is collected in a container. The water is then reused as base for generating other washing liquid.

However, this second treatment method requires managing large amounts of water and at the same time using an operating unit capable of distilling high volumes of water relatively fast. This obviously translates into an increase of construction costs and management costs.

EP 0 624 828 A1 discloses a developer circulating method in a flexographic plate making step and an apparatus therefore. In the method and apparatus, the residual resins originating from the unexposed parts of the printing plates are removed from the developer liquid by flocculation and filtration. The purified developer liquid is fed back into the developer tank.

Given the considerations indicated above, it is the main task of the present invention to provide a new method for treating the water-based washing liquid which makes it possible to overcome the drawbacks of the prior art described above. In the scope of this task, it is a first object of the present invention to provide a treatment unit which promotes the separation of the monomer (or polymer) from the water without using mechanical filters. It is another object of the present invention to provide a treatment unit which makes it possible to effectively recover the water part contained in the washing liquid, whereby greatly reducing the liquid volumes to be managed. A not last object of the present invention is to provide a treatment unit which is reliable and easy to make at competitive costs.

### SUMMARY

The present invention relates to a washing station for washing flexographic plates with water-based washing liquid. The washing station comprises a washing operative chamber and brushing means for brushing said plates. The station according to the invention comprises a treatment unit outside the washing operative chamber for treating a water-based washing liquid used in the chamber itself, wherein said liquid comprises some monomer or polymer detached from said plates during their washing. According to the invention the treatment unit is outside said operative chamber and comprises:
- a first tank for collecting said washing liquid to a predetermined minimum filling level, said monomer or said polymer surfacing in said first tank after said liquid rests for a predetermined interval of time;
- a second tank comprising a first inlet section arranged at a lower height than said minimum filling level of said first tank;
- a third tank for collecting said washing liquid to a predetermined minimum filling level, said monomer or said polymer surfacing in said third tank after said liquid rests for a predetermined interval of time, wherein said second tank also comprises a second inlet section arranged at a lower height than said minimum filling level of said third tank;
- first barrier means, movable between a closing position, in which said first barrier means prevent the communication between said first tank and said second tank and an opening position for which the first tank and the second tank become communicating so that at least said monomer or said polymer surfaced in said first tank can overflow into said second tank at said first inlet section, and
- second barrier means, movable between a closing position, in which said second barrier means prevent the communication between said third tank and said second tank and an opening position for which the third tank and the second tank become communicating so that at least said monomer or said polymer surfaced in said third tank can overflow into said second tank at said second inlet section.

According to an embodiment each of said tanks comprises a bottom wall and a side containing structure defining an upper edge, and wherein said second tank is arranged in a position comprising between the first tank and the third tank. Preferably, the first barrier means and/or said second barrier means comprise at least one barrier which can be turned and translated, in reversible manner, between said closing position and said opening position.

According to another aspect, the treatment unit preferably comprises sensor means for detecting the liquid level in said first tank and/or in said third tank.

In a possible embodiment the treatment unit comprises a first washing liquid supplying line and a second washing liquid supplying line, wherein said first supplying line hydraulically connects said operative chamber to said first tank and said second supplying line hydraulically connects said operative chamber with said third tank. Said treatment unit comprises, for each of said supplying line, a control valve switchable between an opening configuration and a closing configuration.

In another possible embodiment, the treatment unit comprises a water hydraulic feeding line, which makes said first tank and said third tank connectable to a running water source, said feeding line comprising a first terminal part and a second terminal part along which a first adjustment valve and a second adjustment valve are respectively installed.

According to a further embodiment the washing station comprises a main hydraulic distribution line to distribute washing liquid in the operative chamber, wherein said distribution line comprises a first branch and a second branch respectively connected to said first tank and to said third tank, wherein along each of said branches of said distribution line a control valve is provided to regulate the distribution of said washing line, said distribution line connecting said first tank and said third tank to hydraulic terminals placed into the operative chamber. According to a possible embodiment, the washing station comprises a water secondary distribution line to distribute water up to hydraulic terminals inside the chamber. Preferably, the water secondary distribution line is hydraulically connected to the water hydraulic feeding line.

According to another embodiment, the washing station comprises one or more tanks containing additive for the washing liquid and/or for the water introduced into the chamber, said washing station further comprising one or more additive distribution lines for distributing the additive into the operative chamber. According to a further embodiment, the treatment unit comprises a main discharge line for discharging the liquid overflown into said second tank, said discharge line comprising a first circulation pump and a discharge valve upstream of said first pump, said discharge line being hydraulically connected to a distillation unit.

In a possible embodiment, the treatment unit comprises a first secondary discharge line, which connects the first tank to the main discharge line, and a second secondary discharge line, which connects the third tank to the main discharge line, wherein each of said secondary discharge lines comprises a discharge valve which, in an opening condition, makes it possible to discharge the liquid contained in the corresponding tank.

In a further embodiment, the washing station comprises means for heating the washing liquid collected in said first tank and in said third tank.

### LIST OF FIGURES

Further features and advantages of the present invention will be more apparent from the following detailed description provided by way of non-limiting example and illustrated in the accompanying figures.

Figures 1-8 are reference figures.
- Figure 1 is a first diagrammatic view of a treatment assembly of a water-based washing liquid of a washing station;
- Figures 2, 3 and 4 are respectively a second view, a third view and a fourth view of the assembly of Figure 1, each of which relates to an operative step of the assembly itself;
- Figure 5 is a diagrammatic view of a washing station comprising the treatment assembly of Figure 1;
- Figure 6 is a diagrammatic view of a washing station comprising a treatment assembly of Figure 1;
- Figures 7 and 8 are further diagrammatic views of alternative reference embodiments of a treatment unit of a washing station.
- Figure 9 and 10 are schematic views of embodiments of a washing station according to the invention;
- Figures 11 and 12 are schematic view of possible layouts of the tanks of a treatment unit of a washing station according to the invention;
- Figures 13 to 15 are schematic views of the working of the tanks of a possible embodiment of a treatment unit of a washing station according to the invention;
- Figure 16 is a schematic view of an embodiment of the tanks of a treatment unit of a washing station according to the invention;
- Figure 17 is a further schematic view of the tanks of Figure 16 from the observation point indicated by the arrow in Figure 16.

The same reference numbers and letters in the figures refer to the same elements or components.

### DETAILED DESCRIPTION

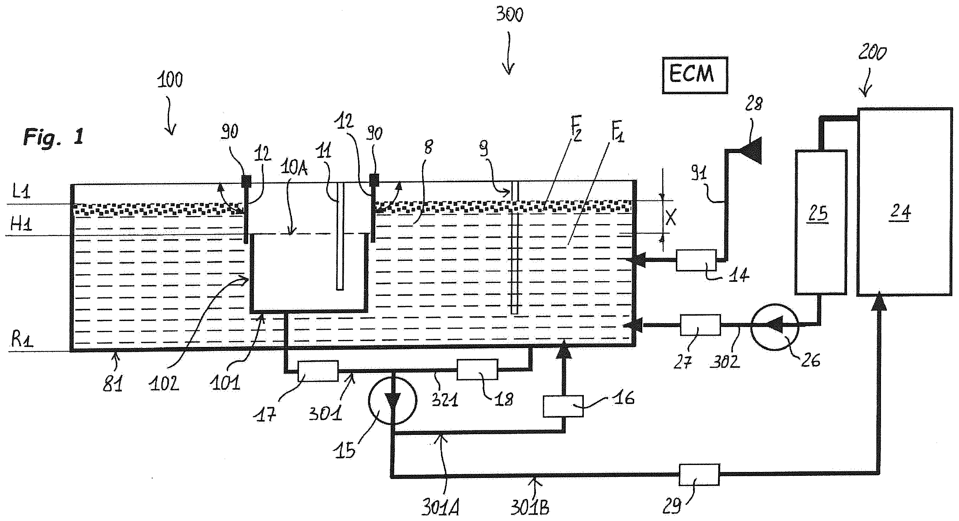

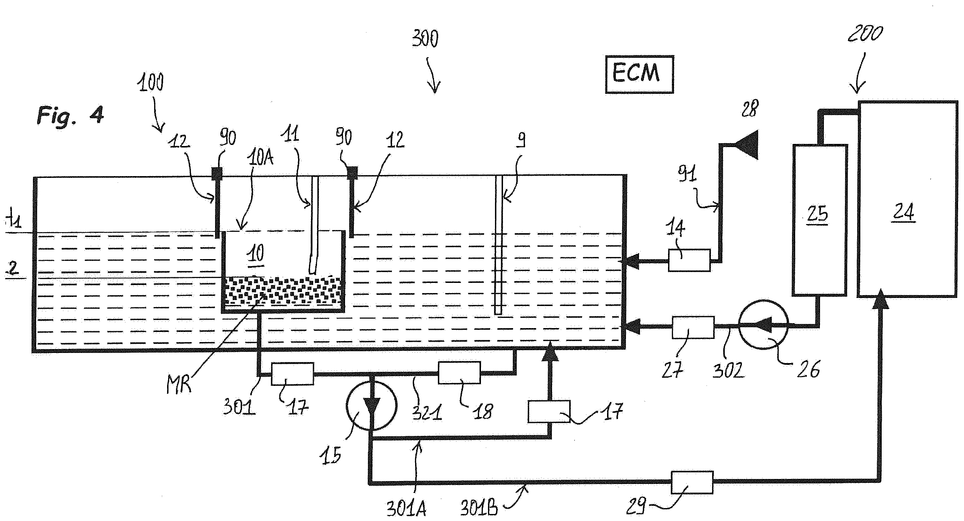

The scope of the invention is defined by the claims, only. Figures 1-8 are reference figures representing illustrative art.

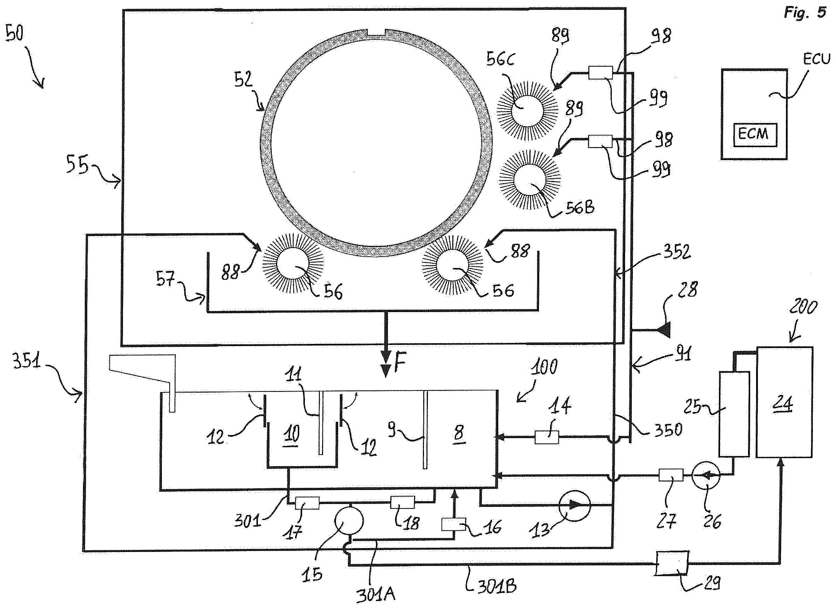

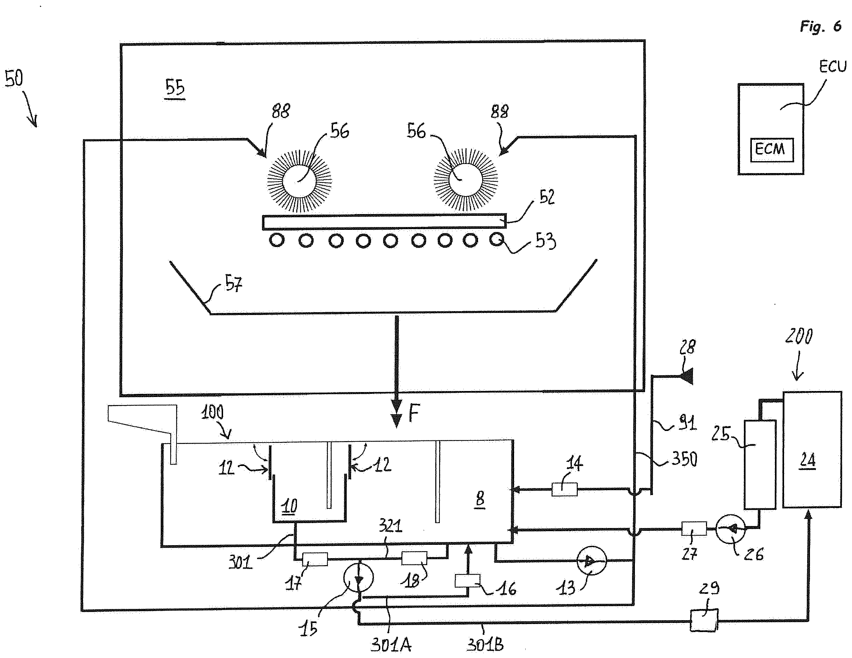

With reference to the mentioned figures, the present invention thus relates to a washing station 50 of a flexographic plate 52 as defined in claim 1 comprising a treatment unit 100 of a water-based washing liquid, used in said washing station 50. At the end of its use, such liquid is constituted of a mixture of water and of monomer (or polymer) detached from the plate 52 by effect of a mechanical brushing, according to a principle known in itself and in all cases reasserted below commenting Figures 5 and 6.

The treatment unit 100 comprises at least a first collecting tank 8 (in the following also indicated with the expression "first tank 8") for collecting the washing liquid. The first tank 8 is preferably arranged in position underneath and outside a washing operative chamber 55 (in the following indicated as "chamber 55") of the washing station 50 in which a flexographic plate 52 is positioned. In such chamber 55 there are arranged means to brush the plate 52 and hydraulic terminals 81, 82 allowing the washing liquid to enter into the chamber 55. The first tank 8 thus is a reservoir from where the liquid for washing the plate 52 is drawn. At the same time, the washing liquid, exiting from the chamber 55, may fall by gravity into the first tank 8 itself. Alternatively, the washing liquid may reach the first tank 8 by means of a hydraulic line 400.

Alternatively, the first tank 8 could also be arranged in a remote position, i.e. in a position independent and separate from the structure of the washing station 50 containing the chamber 55. In this case, the washing liquid could be transferred to the first tank 8 when its composition, in terms of water/monomer (or water/polymer) ratio, is such to require it to be treated.

In all cases, once the liquid has been collected in the first tank 8, the monomer (or polymer) it contains may surface naturally by effect of its specific weight, which is lower than that of water. In this manner, after a given interval of time, in the first tank 8 it is possible to distinguish a first phase F1, mainly constituted of water, and a second phase F2, over the first phase F1, essentially constituted of water-soaked monomer (or polymer). The surfacing of the monomer (or polymer) is achieved by keeping the liquid in the first tank 8 in a resting condition, i.e. avoiding to agitate it or avoiding any operation on it, during said interval of time.

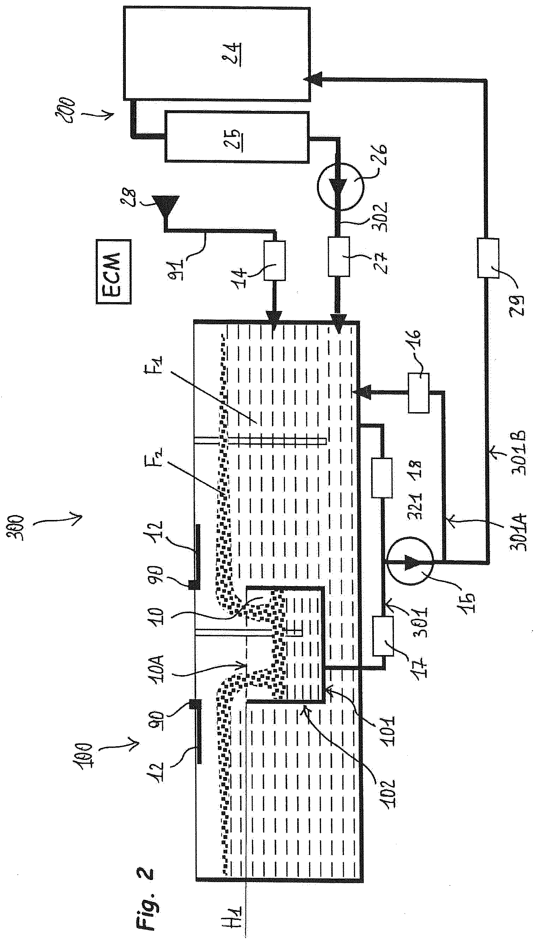

The treatment unit 100 according to the invention also comprises at least a second tank 10 provided with an inlet section 10A. Such inlet section 10A, is arranged at a height H1 which is lower than a predetermined minimum filling level L1 which must be reached by the liquid in the first tank 8. Said minimum level L1 and the height H1 are determined with respect to a same substantially horizontal reference plane R1, which may coincide, for example, with the bottom wall 81 of the first tank 8. The treatment unit 100 comprises barrier means 12 (hereinafter named also only *"barrier 12"*), which are movable between a closing position and an opening position. In the closing position, such barrier means 12 mutually isolate the two tanks 8, 10. In other words, in the closing position, the barrier means 12 prevent the communication between the first tank 8 and the second tank 10, i.e. prevent the liquid of the first tank 8 from entering into the second tank 10. Conversely, when the barrier 12 is in the opening position, the two tanks 8, 10 become communicating so that the liquid part, containing the second phase F2 indicated above, can overflow into the second tank 10. The overflowing into the second tank 10 (diagrammatically shown in Figure 2) ends when the liquid level in the first tank 8 reaches the height H1 of the inlet section 10A of the second tank 10.

For the purpose of the present invention, the heights are considered with respect to a horizontal reference plane.

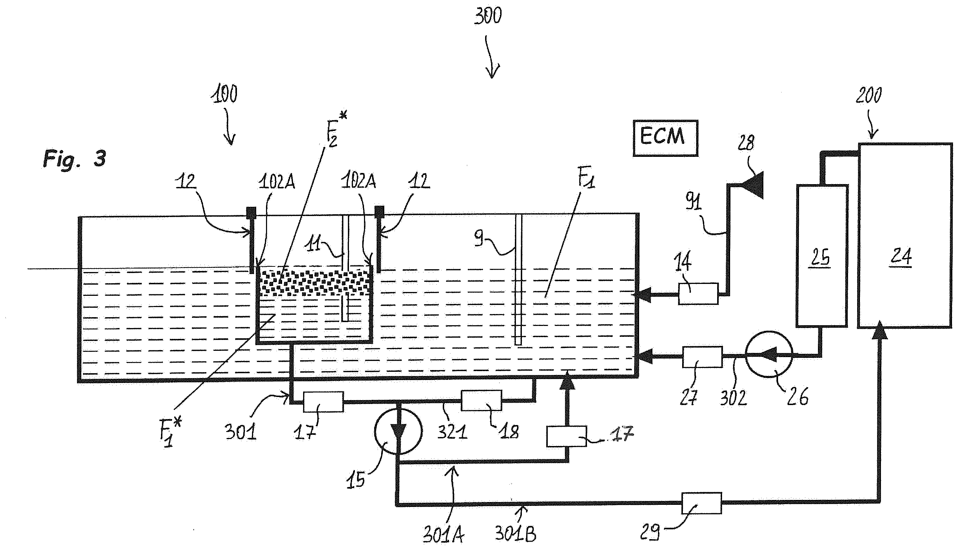

With reference to Figure 3, when the overflowing above is completed, the volume of liquid collected in the second tank 10 is lower than that contained in the first tank 8, in which all the second phase F2 comprising the monomer (or polymer) is advantageously contained, however. Substantially, the liquid initially contained in the first tank 8 is separated into two volumes: a greater first volume still contained in the first tank 8 and substantially constituted of only water (first phase F1), and a smaller second volume, contained in the second tank 10. Advantageously, only the second liquid volume will be later concerned by a process (preferably a distillation process) for separating the water part from the monomer (or polymer). However, since such second volume is much smaller than the first, the dimension/size of the unit used for such separation process may be smaller, with the advantage of cost reduction and easier management.

Figures from 1 to 3 diagrammatically illustrate a treatment assembly 300 of a water-based washing liquid comprising a treatment unit 100. The assembly 300 also comprises a distillation unit 200, known in itself. According to a first embodiment, the first tank 8 of the treatment unit 100 comprises a bottom wall 81 and a side containing structure 82, which delimits a inner space in at least one portion of which the washing liquid coming from a washing station 50 is collected. Similarly, the second tank 10 also comprises a bottom wall 101 and a side containing structure 102. Needing to contain only the liquid volume which overflows following the opening of the barrier 12, the side structure 102 of the second tank 10 may delimit an inner volume which is smaller than that delimited by the side structure 82 of the first tank 8.

According to Figures from 1 to 6, the second tank 10 is placed inside the inner space delimited by the side structure 82 of the first tank 8. Substantially, the space/volume delimited by the side structure 102 of the second tank 10 is inside that delimited by the side structure 82 of the first tank 8.

The bottom wall 101 of the second tank 10 may be arranged at a different height with respect to the bottom wall 81 of the first tank 8, as diagrammatically shown in the figures, but may have the same height.

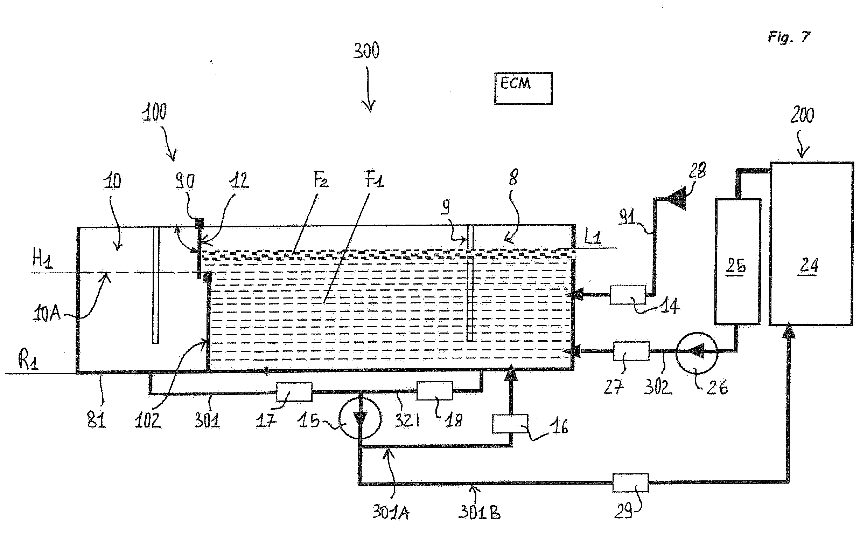

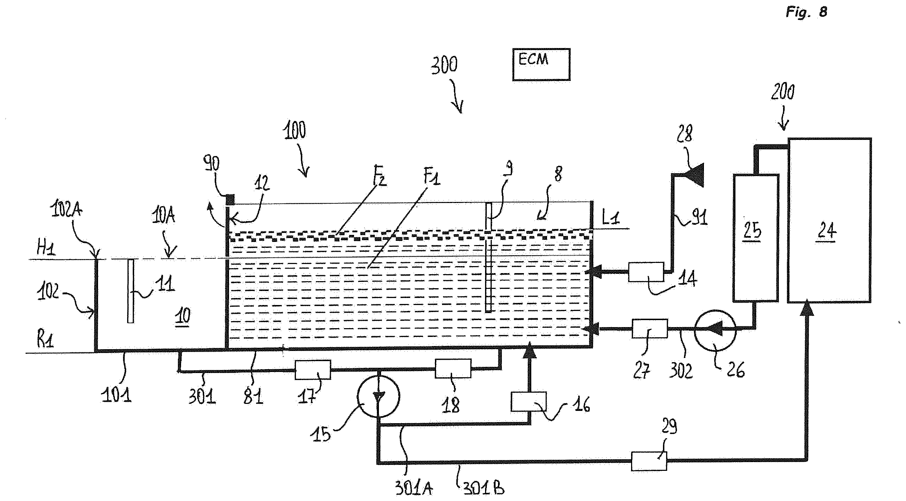

In a reference embodiment diagrammatically shown in Figure 7, the second tank 10 may be arranged outside and in a position adjacent to the first tank 8 (space/volume delimited by the side structure 102 of the second tank 10 external to the side structure 82 of the first tank 8). According to a reference embodiment, diagrammatically shown in Figure 8, the second tank 10 could be defined by a portion of the first tank 8. In this case, the bottom wall 101 of the second tank 10 could be defined by a bottom portion 81 of the first tank 8. At the same time, the inner volume of the second tank 10 could be partially defined by the side structure 82 of the first tank 8.

Preferably, the two tanks 8, 10 are open on the top. In particular, in the second tank 10, the inlet section 10A is delimited by the upper edge 102A of the side containing structure 102. Preferably, at least one portion of such edge 102A develops on a substantially horizontal plane which defines the height H1 of the inlet section 10A. In figures 1-3, the inlet section 10A is shown by a dashed line of height H1 which develops between the opposite edges 102A of the side structure 102.

According to that shown above, the liquid in the first tank 8 is taken up to a minimum predetermined level L1, which will be thus higher than height H1 in order to allow overflowing into the second tank 10. So, the liquid volume corresponding to the height X comprised between the minimum level L1 and height H1 can overflow into the second tank 10. Such height X may be easily established as a function of the volume of the second tank 10 and/or as a function of the height which concerns the second phase F2 described above.

In the reference embodiment diagrammatically shown in Figures 1-4, the barrier means comprise two barriers 12 arranged at opposite sides of the second tank 10. In particular, such barriers 12 may turn, in reversible manner, between the closing position and the opening position. The word *"reversible"* indicates the possibility of moving from the closing position to the opening position, or vice versa from the opening position to the closing position. The rotation may be implemented manually by an operator or more preferably managed by a control module (hereinafter ECM). In this second case, rotation means 90 will be provided to turn the barriers 12 between the two indicated positions.

Alternatively, instead of rotating, the barriers 12 could be configured to translate, in reversible manner, from the closing position to the opening position. Preferably, also such translation may be automated by means of translation means controlled by an ECM. So, in general, movement means are provided to move said barrier means between the two positions defined above.

The position and the configuration of the barrier means may vary according to the configuration of the treatment unit 100, i.e. of the arrangement of the second tank 10 with respect to the first tank 8. In the configurations diagrammatically shown in figures 7 and 8, for example, there may be a single barrier 12, which can be rotated (or alternatively translated) between the closing position and the opening position, and vice versa.

In all cases, in the closing position, the barrier means constitute an extension of the corresponding side of the side structure 102 of the second tank 10 emerging over the corresponding edge 102A. In this manner, when each barrier 12 occupies the closing position, the liquid in the first tank 8 may be taken to a level higher than the height H1 identified by said edges 102A without any overflowing into the second tank 10. Instead, when the minimum level L1 is reached in the first tank 8, each barrier 12 can be opened to allow such overflowing.

Preferably, the treatment unit 100 comprises first sensor means 9, which detect the liquid level in the first tank 8. Even more preferably, the treatment unit 100 comprises a first hydraulic feeding line 91, which connects the first tank 10 to a running water source 28. An adjustment valve 14, preferably a solenoid valve electrically connected to the ECM, is arranged along such hydraulic line.

The first hydraulic feeding line 91 is used to feed the first tank 8 with running water, by opening the adjustment valve 14, if the liquid contained in the first tank is not sufficient to reach the minimum level L1 indicated above. In other words, the first hydraulic line 91 makes it possible to re-establish, in case of need, the ideal conditions to allow the correct overflowing into the second tank 10. In particular, it is worth noting that the water introduced with the first hydraulic feeding line 91 contributes to increasing the volume of the first phase F1 leaving the volume of the second phase F2 unchanged.

Preferably, the treatment unit 100 comprises a main discharge line 301 for discharging the overflown liquid volume into the second tank 10 following the opening of the barrier means 12. Preferably, the main discharge line 301 comprises a discharge valve 17, preferably a solenoid valve, which in an opening condition allows the liquid in the second tank 10 to exit. A first circulation pump 15 is arranged downstream of the discharge valve 17, instead.

Preferably, a first hydraulic branch 301A, which connects the main discharge line 301, and thus the second tank 10, to the first tank 8, is arranged downstream of the first pump 15. A first shut-off valve 16, preferably a solenoid valve, is arranged along this first branch 301A. So, when the discharge valve 17 and the first shut-off valve 16 are open, the two tanks 8, 10 communicate, and by effect of the first pump 15 a water part in the second tank 10 may be transferred into the first tank 8.

With this regard, as diagrammatically shown in Figure 3, after the liquid overflows into the second tank 10, it is left in a resting condition to allow the monomer (or polymer) to surface, similarly to that done in the first tank 8. Advantageously, after a given interval of time, also in the second tank 10 it will be possible to distinguish a first phase F1*, substantially constituted of water, and a second phase F2*, over the first phase F1*, constituted of surfaced water-soaked monomer (or polymer). Through the first hydraulic branch 301A, and following the opening of the discharge valve 17 and of the first shut-off valve 16, most of the water constituting the first phase F1* is advantageously returned to the first tank 8. In this manner, a first step of discharging is performed at the end of which only a residual mixture, comprising the second phase F2* and a very small amount of water, will remain in the second tank 10. The successive distillation process, by means of which the monomer (or polymer) is separated from the water, may be advantageously rapid precisely because of the small amount of water present in said residual mixture. Preferably, the first shut-off valve 16 keeps an opening condition until the liquid overflown into the second tank 8 drops under a second minimum level L2. With this regard, the treatment unit 100 preferably comprises second sensor means 11, which detect the liquid level, i.e. the quantity/volume thereof, in the second tank 10. Preferably, the second sensor means 11 and the first shut-off valve 16 are electrically connected to the control module ECM. The latter controls the opening/closing of the first shut-off valve 16 as a function of the liquid level in the second tank 10 detected by the second sensor means 11.

According to another aspect, a second hydraulic branch 301B is arranged downstream of the first pump 15, to connect the main discharge line 301 to a distillation unit 200. In particular, the second branch 301B is used to make a second step of discharging, successive to the first step of discharging described above, so as to complete the emptying of the second tank 10.

Also developing downstream of the first circulation pump 15, the second branch 301B is hydraulically parallel to the first branch 301A. A second shut-off valve 29, which allows said residual mixture (pushed by the first pump 15) to either reach the distillation unit 200 or not, is arranged along the second branch 301B. Such second shut-off valve 29, thus remains closed during the first step of discharging of the tank 10, i.e. when the first shut-off valve 16 is open.

The second shut-off valve 29 is also preferably a solenoid valve electrically connected to the control module ECM which controls its activation/deactivation, i.e. its opening/closing, as a function of the liquid in the second tank 10 detected by the second sensor means 11. The module ECM keeps the second shut-off valve 29 open until the second tank 10 is empty, condition which can be detected, for example, again by means of the second sensor means 11.

The module ECM to which reference was made several times above is shown in Reference Figures 1-4, 7 and 8. The electric connections by means of which the module ECM is connected to the various aforesaid components (barrier means, sensor means, valves, circulation pump etc.) are not shown for the sake of clarity of these Figures.

The distillation unit 200 may have a configuration known in itself, which includes a distillation module 24, configured to evaporate the water part, and a container 25, in which the distilled water is collected. In accordance with a possible embodiment, the first unit 100 or the treatment assembly 300, comprises a second hydraulic feeding line 302, which connects such container 25 with the first tank 8. A second circulation pump 26 and a further shut-off valve 27, both preferably controlled by the same control ECM, are arranged along such second hydraulic line 302. The distilled water is thus transferred in the first tank 8 following the actuation of the second pump 26 and the opening of the shut-off valve 27.

As a whole, the treatment unit 100 and the distillation unit 200 make it possible to recover the entire water part contained in the liquid volume which overflows into the second tank 10 following the opening of the barriers 12. A first fraction of this water may return to the first tank 8 during the first step of discharging, i.e. through the first hydraulic branch 301A, while the remaining fraction is distilled in the distillation unit 300 and conveyed back into the first tank 8 through the second hydraulic line 302. However, in a possible reference embodiment, the discharge of the second tank 10 may be performed in a sole step, namely by means of the second branch 301B. In other words, the first branch 301A could be missing.

According to a reference embodiment visible in the figures, the treatment unit 100 comprises a second discharge line 321 which connects the first tank 8 to the main discharge line 301 upstream of the first circulation pump 15. A second discharging valve 18 which, in an opening condition allows the extraction, by pumping, of the liquid contained in the first tank 8, is located along the second discharge line 321. The second discharge line 321 makes it possible to transfer the liquid contained in the first tank 8 directly into the distillation unit 200, without the passage into the second tank 10. As will be described in greater detail below, this direct transfer is preferably actuated during a stop time (time of non-use) of the washing station 50, e.g. during the night. Substantially, during such period of time, the liquid is subjected to the distillation treatment so as to eliminate the monomer (or polymer). When the container 25 is full, the distilled water is returned to the first tank 8.

In view of what above, in general, the present invention relates to a method for treating the water-based liquid used in a washing station of flexographic plates, the method is defined in claim 16. Figures 5 and 6 are diagrammatic views of reference embodiments of a washing station 50 which in all cases comprises a washing operative chamber 55 in which a flexographic plate 52 is treated. Brushing means are arranged inside this chamber 55, which allow the brushing of the plate 52. Such brushing means may vary according to the washing method provided for the plate. In the washing station 50 diagrammatically shown in Figure 5, for example, the plate 52 is arranged about a cylinder 59 which may rotate about its rotation axis 590. The brushing means comprise rotating brushes 56, the rotation axis of which is parallel to that of the cylinder 59.

Instead, in the embodiment diagrammatically shown in Figure 6, the plate 52 moves on a plane defined by moving rollers 53. Also in this case, the brushing means may comprise rotating brushes 56 or alternatively brushes which translate on a plane parallel to that of movement of the plate 52.

In the washing station 50, the treatment unit 100 is arranged preferably in a position under the washing chamber 50. During the normal operation of the washing station 50, the first tank 8 acts as reservoir containing the washing liquid used in the chamber 55. With this regard, a hydraulic distribution line 350, which connects the first tank 8 to the hydraulic terminals 88 arranged in the chamber 55 and through which the washing liquid exits, is arranged. Preferably, such hydraulic terminals 88 are arranged near the brushes 56 acting on the plate 52. Circulation along the hydraulic distribution line 350 is guaranteed by a further circulation pump 13. As diagrammatically shown in figures 5 and 6, the distribution line 350 may comprise a plurality of branches 351,352, each of which to take the washing liquid to a corresponding hydraulic terminal 88.

With reference to the diagrammatic view in Figure 5, the first hydraulic line 91 shown above may comprise a plurality of branches 98 to take running water at corresponding hydraulic terminal 89 to inside the chamber 55, e.g. at further rinsing brushes 56B and/or drying brushes 56C. Each of these branches 98 may comprise a valve 99 to allow the running water flow to the corresponding hydraulic terminal 89 or not.

Inside it, the chamber 55 may preferably also comprise a washing water collection structure, indicated by reference numeral 57 in Figures 5 and 6. Such collection structure will convey the washing liquid, which will be discharged into the first tank 8 of the treatment unit 100, as shown by the arrow F again in Figures 5 and 6. The operation of the washing station 50 is managed by a control unit ECU in which the module ECM which manages the components of the treatment unit 100 may be advantageously integrated. In other words, the operation of the treatment unit 100 is managed by the same unit used for controlling the means which implement the washing of the plate 52. The control unit ECU containing the module ECM is indicated in Figures 5 and 6. Also in this case, the electrical connections which connect the control unit to the components of the washing station 50 and/or of the treatment unit 100 are not shown.

The washing station 50 according to the invention may be provided with the entire treatment assembly 300 according to the invention and thus also comprises the distillation unit 200 indicated above. The latter may be arranged in a position either adjacent to the chamber 55 or not. In all cases, the second branch line 301B will make the second tank 10 and/or the first tank 8 hydraulically communicating with the distillation unit 200.

The operation of the treatment unit 100 considered integrated in a washing station 50 is explained below according to the diagrammatic views shown in Figures 5 and 6. During the washing of the plates 52, the barrier 12 keeps the closing position and the two tanks 8, 10 of the unit itself are physically separated in the treatment unit 100.

The control unit ECU of the washing station 50 detects the number of plates 52 which are processed in the chamber 55. After the washing of a given number of plates, said ECU indicates the need to start the washing water treatment procedure, i.e. to eliminate the monomer (or polymer) from the liquid itself. After this indication, the washing station 50 will not accept the introduction of further plates and the operator will start the treatment procedure.

The first sensor means 9 detect the liquid level in the first tank 8. If such level is under the predetermined minimum level L1, the ECU controls the opening of the adjustment valve 14. Feeding with running water continues until such minimum level L1 is reached.

Having reached this condition, the liquid in the first tank 8 is made to rest for a first predetermined interval of time, e.g. 30 minutes. In this interval of time, the monomer (or the polymer) surfaces towards the top, while the water part decants under the surfaced monomer (or polymer). So, the two phases F1 and F2, defined above, are formed in this interval of time.

At the end of the first interval of time, the ECU sends a control signal to the moving means (e.g. in form of actuators) of the barriers 12, following which the barrier 12 moves from the closing position to the opening position, starting the overflowing of the liquid from the first tank 8 to the second tank 10. The water conveys the monomer (or polymer) into the second tank 10 until the overflowing ends, i.e. until the level of liquid in the first tank 8 reaches the height of the inlet section 10A, i.e. the height of the upper edge 102A of the side containing structure 102.

Having reached such condition, detected by the first sensor means, the ECU instructs said moving means to close of the barriers 12. At this point, the liquid overflown into the second tank 10 is keep in a resting condition to allow the monomer (or polymer) to surface again. In this manner, in the second tank 10 the first phase F1*, constituted substantially of water, and a second phase F2*, over the first because lighter, comprising the surfaced water-soaked monomer (or polymer), are recomposed.

At the end of this second interval, the ECU sends a control signal to the discharge valve 17 and to the first shut-off valve 16, after which such valves open. Conversely, the second valve 29 and the third valve 18 remain closed. At the same time, the ECU activates the first circulation pump 15. This condition activates the first step of discharging of the second tank 10, by effect of which a fraction of the decanted water (i.e. part of the first phase F1*) is returned to the first tank 10, exploiting the first branch 301A indicated above.

When the liquid in the second tank 10 reaches a second predetermined level L2, detected by means of the second sensor means 11, the ECU controls the closing of the first shut-off valve 16 and the opening of the second shut-off valve 29. In this manner, a second step of discharging is actuated, during which the residual mixture, remained in the second tank 10, is sent to the distillation unit 20 along the second hydraulic branch 301B.

Such residual mixture is mainly composed of monomer (or polymer), and by a much lower residual volume of water with respect to that previously overflown into the second tank 10 by effect of the first step of discharging. In this manner, the recovery of the water and of the distillation of water in the distillation unit 200 is fast and inexpensive. With this regard, a smaller size distillation unit 200 compared to those traditionally used in the known systems for treating the washing liquid may be used.

At the end of the emptying of the second tank 10, the ECU controls the closing of the discharge valve 17 and the stopping of the first circulation pump 15. At the end of the distillation process, the ECU controls the actuation of the second circulation pump 26 and the opening of the shut-off valve 27 arranged along the feeding line 302. In this manner, the distilled water collected in the container 25 is sent to the first tank 8 of the treatment unit 100.

From the description of the operation shown above, it is apparent that all the water overflown into the second tank 10 is advantageously returned to the first tank 8 of the treatment unit 100 to be then reused in the washing station 50 for washing another series of plates. This aspect translates into a considerable containment of the liquid/water volumes needed for the operation of the machine, with obvious advantages in terms of economy and environment impact.

As mentioned above, when the washing station 50 is not used, e.g. at the end of shift or during the night, the operator may advantageously start, via the ECU, a distillation procedure of the washing liquid collected in a first tank 8. In order to activate such procedure, the ECU controls the opening of the second discharge valve 18 and the second shut-off valve 29 and the concurrent activation of the first circulation pump 15. The first discharge valve 17 and the first shut-off valve 16 are kept closed. The washing liquid contained in the first tank 8 is thus pumped directly towards the distillation unit 200 through the second discharge line 321 and the second branch 301B.

Preferably, during the distillation procedure, the first pump 15 is activated at intervals of time. Substantially, the first pump 15 is activated for a certain time and successively deactivated until the pumped liquid has been completely distilled and collected in the container 25. At this point, the first pump 15 is reactivated again so as to pump a second liquid volume into the second treatment unit.

Again with reference to such distillation procedure, once the container 25 is full of distilled water, the ECU controls the opening of the third shut-off valve 27 e the activation of the second pump 26 so as to transfer the distilled liquid back into the first tank 8. Appropriate sensor means are arranged to provide information concerning the water level reached in the container 25 to the ECU. Advantageously, at the end of the distillation procedure described above, the liquid contained in the first tank 10 will be substantially regenerated, i.e. cleaned from the monomer (or polymer). As a whole, it is worth noting that by means of the treatment unit 100, and more in general by means of the treatment assembly 300, the water part contained in the washing liquid is continuously and advantageously recovered with obvious advantages in terms of consumption. Losses of load are reabsorbed by means of the first feeding line 301 indicated above.

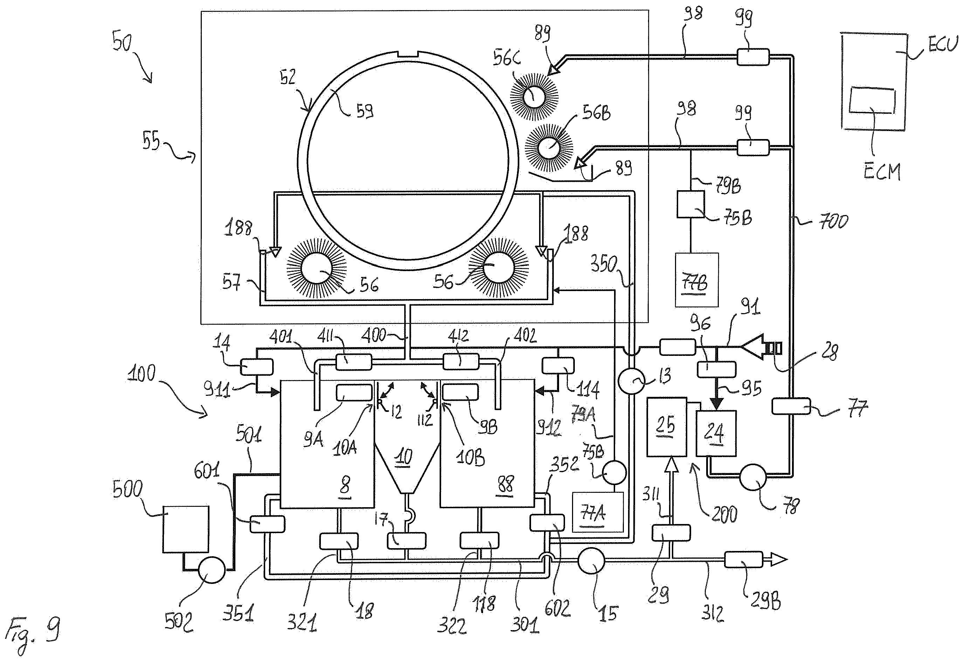

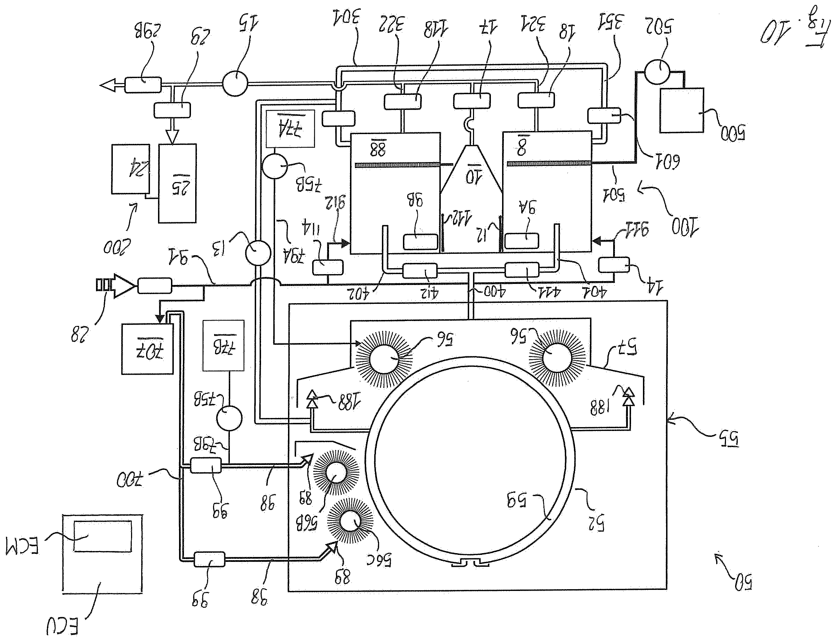

Figures 9 and 10 show embodiments of the washing machine 50 according to the invention wherein the treatment unit 100 which differs from the reference embodiments in Figures 1-8 for the presence of a third tank 88 for collecting the washing liquid. The third tank 88 has the same purpose of the first tank 8, namely collecting the washing liquid used in the washing operative chamber 55. The washing liquid collected in the third tank 88 is kept in a resting condition for the separation of the first phase F1, mainly constituted of water, and of the second phase F2, over the first phase F1, essentially constituted of water-soaked monomer (or polymer).

Therefore, the embodiment in Figure 9 comprises three tanks: the first tank 8 and the third tank 88, which act as collecting tanks for the washing liquid used in the operative chamber 55, and the second tank 10 in which the first phase F1 surfaced in the collecting tanks 8, 88 may overflow. During the washing process, the two collecting tanks 8, 88 act as reservoirs of the washing liquid.

For this reason, in view of the presence of the two collecting tanks 8, 88, the treatment unit 100 comprises first barrier means 12 and second barrier means 112 movable, in a reversible manner, between a closing position and an open position. When in the closing position, first barrier means 12 avoids the communication between the first tank 8 and the second tank 10; on the contrary, when in the opening position, the first barriers means 12 make these two tanks 8-10 communicating. Analogously, in the closing position, the second barrier means 112 make the third tank 88 and the second tank 10 mutually isolated, namely they prevent the communication between these tanks 88-10. Conversely, in the opening position, the second barrier means 112 make the third tank 88 communicating with the second tank 10 so that the second phase F2 can overflow in the second tank 10, in accordance with the principles above.

The second tank 10 comprises a first inlet section 10A for the washing liquid overflowing from the first tank 8, and a second inlet section 10B for the washing liquid overflowing from the third tank 88. The washing liquid is collected in the first tank 8 and in the third tank 88 until a predetermined minimum level L1, L1* which is higher that the height H1, H1* respectively of the edges 102A, 102B of the side containing structure 102 of the second tank 10 which define the inlets 1 sections 0A, 10B. On this regard, the inlets 10A, 10B may have the same height (H1=H1*), but they could have also different heights. At the same time, also the predetermined levels L1, L1* could be the same or could be different.

In any case, when the second barrier means 12, 112 are moved in the opening position, the liquid volume corresponding to the height X1, X1* comprised between the minimum level L, L1* and the height H, H1* overflows into the second tank 10. Such height X, X* can be established as a function of the volume of the second tank 10 and/or of the height which concerns the second phase F2 generated in the corresponding collecting tank 8, 88.

The level L1, L1* of the washing liquid in the two collecting tanks 8, 88 is controlled by means of corresponding sensor means 9A,9B which are electrically connected to the ECM of the treatment unit 100. The movement of the barrier means 12, 112 is performed by means of corresponding actuators operated by the ECM. Also in this case, the ECM is preferably in the ECU of the washing station 50.

The first tank 8 and the third tank 88 are separated and supplied independently with washing liquid coming from the operative chamber 55. More precisely, a first washing liquid supplying line 401 and a second washing liquid supplying line 402 are provided. These two lines 401, 402 can be hydraulically connected to the chamber 55 independently or, as shown in Figure 9, they can develop from a main hydraulic line 400 exiting from the chamber 55.

Along the first line 401 a first control valve 411 (e.g. a shut-off valve) is installed. In a closing configuration, such a valve 411 avoids the hydraulic communication between the chamber 55 and the first tank 8, while in an opening configuration, the washing liquid can reach the first tank 8. Similarly, along the second line 402 a second control valve 412 is provided to avoid or to allow the hydraulic communication between the chamber 55 and the third tank 88. That means, the washing liquid can be collected in the third chamber 88 only when the second valve 412 is in the opening configuration.

The first control valve 411 and the second control valve 412 are electrically controlled by means of the ECM or by the ECU. In particular, the ECM or the ECU, intervenes on the shut-off valves 411, 412 so that when the first valve 411 is in the opening configuration, the second control valve 412 is kept in the closing configuration and vice-versa. That means when the washing liquid is collected in the first tank 8 (first control valve 411 valve in the opening configuration) the washing liquid flow along the second branch 402 is stopped (second control valve 412 in the closing configuration) and vice versa.

As a fact, with respect to the embodiments with two tanks (Figures 1-8), the third tank 88 improves advantageously the productivity of the wasting station 50. Indeed, during the treatment of the washing liquid collected in the first tank 8, the washing liquid previously collected in the third tank 88 can be re-used in the chamber 55 and vice-versa. That means the two collecting tanks 8, 88 advantageously allow a continuity of the washing process. Further, the presence of two collecting tanks 8, 88 also allows to process flexographic plates at least of two different types, namely plates which require a different washing liquid. Indeed, each of the collecting tanks 8, 88 can be used to collect washing liquid usable for a specific type of plate. Each of the collecting tanks 8, 88 may be used as a reservoir of a specific washing liquid.

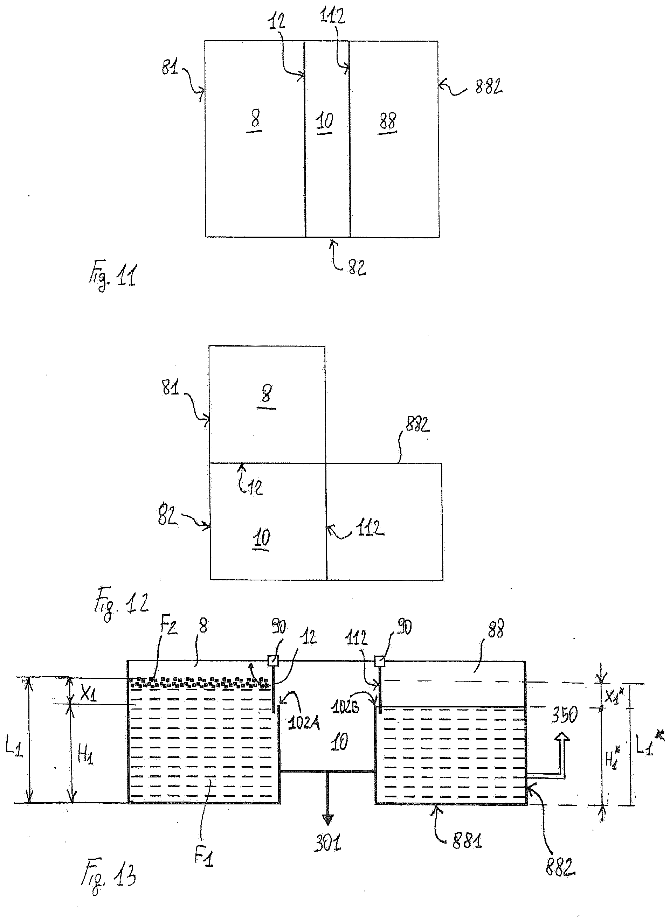

According to a possible installation, the second tank 10 is arranged in a position interposed between the first tank 8 and the third tank 88. In other words, with respect to the second tank 10, the first tank 8 and the third tank 88 are arranged on opposite sides. This arrangement can be seen also in Figure 11 that shows the layout of the three tanks 8, 10, 88. For this layout, the first barrier means 12 substantially face the second barrier means 112.

Figure 12 is a scheme of a further possible layout of three tanks 8, 10, 88. More in detail, the first barrier means 12 and the second barrier means 112 are located on sides of the second tank 10 not opposite each other. The first barrier means 12 and the second barrier means 112 are positioned accordingly.

The third tank 88 may have a structure substantially corresponding to that of the first tank 8, but can have a different shape. In any case, also the third tank 88 comprises a bottom wall 881 and side containing structure 882 which delimits an inner space in which the washing liquid coming from the chamber 55 via the second branch 402 can be collected. Preferably, such inner volume corresponds substantially with the inner volume delimited by the structure 82 of the first tank 8. In other words, the first tank 8 and the third tank 88 preferably contain the same volume of liquid. More preferably, the first tank 8 and the third tank 88 have the same structure and their bottom walls 81, 881 are at the same height, with respect to a reference plane substantially horizontal.

According to another aspect, a water feeding line 91 is provided to feed the first tank 8 and the third tank 88 with running water coming from a source 28. More precisely, the feeding line 91 comprises a first terminal part 911 and second terminal part 912 along which a first adjustment valve 14 and a second adjustment valve 114 are respectively installed. The terminal parts 911, 912 allow to feed the corresponding collecting tank 8, 88 with water when the washing liquid in the corresponding tank 8, 88 is not sufficient to reach the minimum level L1, L1*. This in order to assure the ideal conditions to allow the correct overflowing into the second tank 10.

According to another aspect, also when the washing station 50 has *"a three tanks configuration"* as above, a main discharge line 301 is provided for discharging at least the liquid overflow in the second tank 10, following the opening of the first barrier means 12 or of the second barrier means 112. A discharge valve 17, which allows (in an opening condition) or avoids (in a closing condition) the liquid in the second tank 10 to exit, is provided.

The first tank 8 is hydraulically connected to the main discharge line 301 by a first secondary discharge line 321 along which a discharge valve 18 is installed. Analogously, the third tank 88 is hydraulically connected to the main discharge line 301 by a second secondary discharge line 322 along which a while a second discharge valve 118 is installed. When in an opening condition, each of the discharge valves 18, 118 allows the extraction, by pumping, of the liquid contained in the corresponding tank 8, 10. For this purpose, the first pump 15 is provided along the discharge line 301.

In accordance to a principle already explained for the reference embodiments having two tanks (Figures 1-8), the discharging valves 18, 118 are activated (opening condition) preferably during a stop time of the washing station 50 in order to treat all the washing liquid in a distillation unit 200 according to a principle above explained.

The main discharge line 301 also comprises a shut-off valve 29 downstream the first pump 15. When in an opening condition, the shut-off valve 29 allows the liquid discharged from one or more of the tanks 8, 10, 88 to reach the distillation unit 200. In a possible embodiment (shown in Figure 9), the discharge line 301 may comprise two terminal parts, a first terminal part 311 directed to the distillation unit 200 (along which the above shut-off valve 29 is installed) and a second terminal part 312 hydraulically connected to a collecting container or a hydraulic disposal circuit. Along the second terminal part 312 a further shut-off valve 29B can be installed. Preferably, the latter is activated (opened condition) when the shut-off valve 29 is closed and vice versa. Overall, the two shut-off valves 29, 29B of the discharge line 301 allow to control the direction of the liquid flow coming from the tanks 8, 10, 88.

In a possible embodiment (for example shown in Figure 9), the washing station 50 is provided with a main hydraulic distribution line 350 which connects the two collecting tanks 8, 88 with the hydraulic terminals 188 arranged in the chamber 55 from which the washing liquid exit. Preferably the distribution line 350 comprises a first branch 351 and a second branch 352 respectively connected to the first tank 8 and to the third tank 88. Along each of said branches 351, 352 of the distribution line 350, a corresponding control valve 601, 602 (i.e. a shut-off valve) is provided to regulate (allowing or avoiding) the flow. Along the hydraulic line 350 a second pump 13 is provided for pumping out the washing liquid (second phase F2) from the corresponding collecting tank 8, 88 up to the hydraulic terminals 188.

According to a further aspect, the treatment unit 100 may also comprise means for heating the washing liquid collected in the first tank 8 and/or in the third tank 88. This to further the separation of the second phase F2 above the first phase F1.

According to a possible embodiment shown in Figure 9, such heating means comprise a hot liquid source 500 (i.e. water) and a heating circuit 501 (i.e. closing loop) which develops at least partially inside the first tank 8 and/or in the second tank 88. A circulation pump 502 is provided for pumping the hot liquid from the source 500 into the heating circuit 501 so that the washing liquid collected in the first tank 8 and/or in the third tank 88 is heated by the thermal exchange with the hot liquid circulating in the circuit 501. The increase of the thermal agitation of the washing liquid and consequently the separation of the monomer (or polymer) from the water.

According to a possible embodiment (shown in Figure 9), the washing station 50 comprises a water secondary distribution line 700 to distribute water to a corresponding hydraulic terminal 89 inside the chamber 55, e.g. at further rinsing brushes 56B and/or drying brushes 56C. The secondary distribution line 700 comprises a plurality of branches 98 to take the water to a corresponding hydraulic terminal 89 inside the chamber 55, e.g. at further rinsing brushes 56B and/or drying brushes 56C. Each of these branches 98 may comprise a control valve 99 to allow or to avoid the water flow to the corresponding hydraulic terminal.

As above indicated, the distillation unit 200 preferably comprises a distillation module 24 and a container 25 in which the distillated water is collected. According to a possible embodiment shown in Figure 10, the water secondary distribution line 600 is connected to the container 24 to distribute the distillated water to said hydraulic terminal 89 inside the chamber 55. Along the secondary distribution line 700 a circulating pump 78 and a control valve 77 are preferably installed to control the flow of distillated water.

According to another embodiment, the washing station 50 can comprise one or more secondary tank 77A, 77B containing additive usable for the washing or for the rinsing of the flexographic plate. In this regard, a first secondary tank 77A may contain a first additive for the washing liquid, while a second secondary tank 77B may contain a second additive for the rinsing. For each of the secondary tank 77A, 77B a corresponding additive distribution line 79A, 79B is provided along which corresponding pumping means 75A, 75B are installed.

According to a further possible embodiment, the container 25 of the distillation unit 200 can be hydraulically connected to the feeding line 91 by means of a hydraulic line 95 along which a control valve 96 (e.g. of the shut-off type) is installed. This solution allows to mix the distilled water with running water keeping filled the container 25 and assuring a constant liquid source for the secondary distribution line 700.

According to a further embodiment (shown in Figure 10), alternative to that just above discloses (shown in Figure 9), the secondary distribution line 700 is hydraulically connected to the feeding line 91. Along the secondary distribution line 700 heating means 707 are installed for heating the water addressed to hydraulic terminals 89 inside the chamber 55, e.g. at rising brushes 56B and/or drying brushes 56C. Such heating means 707 can comprise, for example, a further container electrically heated or other means technically equivalent.

The operation of the washing station having three tanks 8, 10, 88 is explained below with reference to the schematic views in Figures 13-15. The control unit ECU of the washing unit detects the number of plates 52 which are processed. When a pre-established number is reached, the ECU starts the treatment procedure. The washing liquid is collected in one of the collecting tanks 8,88 (for example the first tank 8) up to reach the predetermined minimum level L1 (see Figure 13). Then the washing liquid is kept in a resting condition for predetermined interval of time in order to allow the separation of the two phases F1, F2. After this time, the ECU operates the barrier means 12 in the opening position starting the overflowing of the liquid (phase F2) in the second tank 10. Then the liquid overflown is discharged by means of the main discharged line 301. For this purpose, the ECU activates the discharge valve 17 and the first pump 15.

During the treatment of the washing liquid, or immediately after, the washing liquid previously collected in the other tank (in the third tank 88 to continue the example) may be introduced in the chamber 55 by means of the distribution line 350 so that the washing process is not interrupted. For this purpose, the ECU actuates the corresponding circulation pump 13 and the corresponding control valves 601,602. In other words, the washing process may continue advantageously also during the washing liquid treatment.

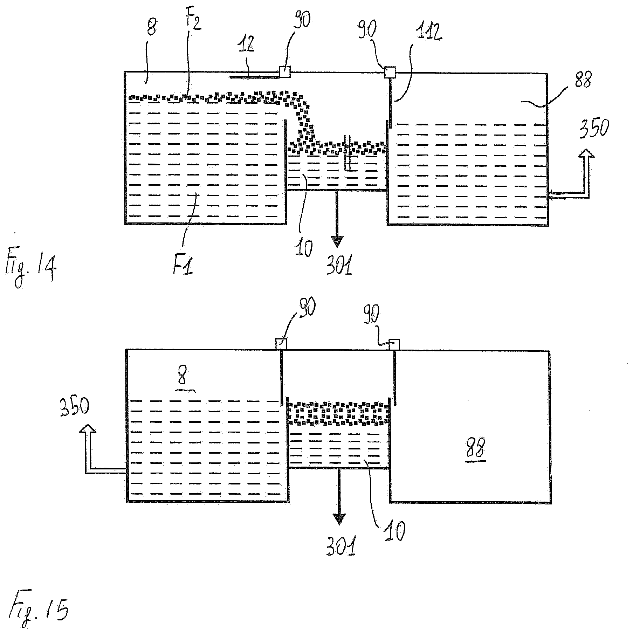

With reference to Figure 15, at the end of the treatment process, the first tank 8 contains washing liquid ready to be distributed into the operative chamber 55. Instead, the third tank 88 is substantially empty to be filled with washing liquid to be treated.

As above anticipated, when the washing station 50 is used for plates of two different typology which require two different washing liquid, each of two collecting tanks 8, 88 can be used for collecting a specific washing liquid. In this case, until the washing process a first specific washing liquid, the latter is collected in and distributed from same collecting tank 8, 88, according to the same principle above disclosed for the reference embodiments in Figures 1-8.

When the plates 52 to be washed require a second specific washing liquid, the latter is distributed from, and subsequently collected in, the other collecting tank 8,88. In this case, the first distribution of the second specific washing liquid can be performed during the treatment of the first specific washing liquid.

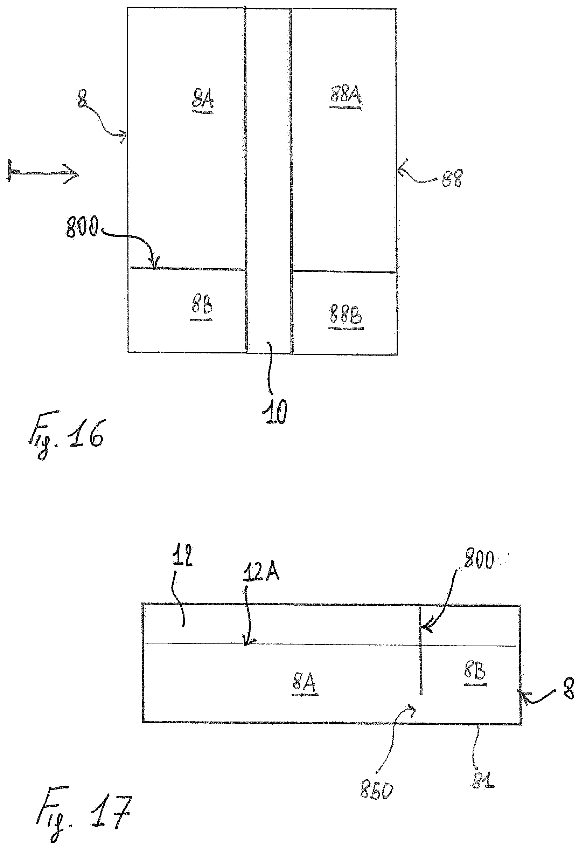

According to a further embodiment schematically shown in Figures 16 and 17, at least one or the collecting tanks (first tank 8 and/or third tank 88) may comprise at least one internal separation wall 800. The latter separates the volume of the tanks in two regions 8A-8B, 88A-88B defining, with the corresponding bottom wall 81, 811, a passage 850 between the two regions. Preferably, this separation wall 800 develops on a plane substantially orthogonal to the plane in which the corresponding barrier means 12, 122 are placed when considered in the closing position. The washing liquid coming from the operative chamber 55 is discharged in one of the regions 8A-8B, 88A-88B of the tank 8, 88 and through the passage 850 spreads also in the other region. It has been seen that this solution improves the separation of the monomer (or polymer) from the water, namely improves the separation of the two phases F1, F2 above defined.

In view of what just above, the present invention also relates to a further method for treating the water-based liquid used in a washing station of flexographic plates, wherein such method includes at least the steps of:
A1) providing, outside the operative chamber 55 of the washing station 50, a first tank 8, a second tank 10 and a third tank 88, wherein the first tank 8 and the third tank 88 are provided for collecting the washing liquid used in the chamber 55 and wherein the second tank 10 comprises an inlet section 10A;
B1) arranging the second tank 10 with respect to the first tank 8 and to the third tank 88 so that its inlet section 10A is at a lower height H1 than a predetermined minimum filling level L1 for the washing liquid L1, L1* in the first tank 8 and in the third tank 88;
C1) providing, between the first tank 8 and the second tank 10, first barrier means 12, and between the third tank 88 and the second tank 10, second barrier means 112, wherein said first barrier means 12 and said second barrier means 112 are configured to assume a closing position for which the corresponding tanks 8-10, 88-10 are not communicating, and an opening position for which the liquid volume of said one the collecting tank 8, 88 comprised between the corresponding height H1, H1* of the inlet section 10A and said minimum level L1, L1* can overflow into the second tank 10;
D1) filling one tank, among the first tank 8 and the second tank 88, with the washing liquid (used in said operative chamber 55) to be treated in order to reach said predetermined minimum filling level L1, L1* wherein such filling is implemented with the corresponding barrier means 12, 112 in said closing position;
E1) keeping, at the end of said step D1), the washing liquid in a resting condition for a first predetermined interval of time, allowing the surfacing of the monomer (or polymer) contained in the liquid and the decanting of the water under the surfaced monomer (or polymer);
F1) displacing said corresponding barrier means 12, 112 to said opening position to allow the overflowing of said liquid volume into said second tank 10.

Preferably, the method comprises also the steps of:
G1- discharging the washing liquid overflown in the second tank 10;
H1- distributing inside the operating chamber 55 the water decanted in said one tank, among the first tank 8 and the second tank 88.

According to a possible embodiment, the method also comprises the step of filling the first tank 8 or the third tank 88 as a function of the kind of washing liquid used in the washing station 50.

The described technical solutions allow to fully achieve the predetermined tasks and objects. In particular, the treatment unit according to the invention makes it possible to separate the monomer (or polymer) contained in the water-based washing liquid without using mechanical filters. Concurrently, the treatment assembly according to the invention advantageously makes it possible to recycle the washing liquid water, minimizing the liquid volumes to be managed. This aspect is very advantageous in economic terms.

## Claims

1. A washing station (50) for washing flexographic plates (52) with water-based washing liquid, wherein said washing station (50) comprises an operative chamber (55) and brushing means for brushing said plates (52), wherein said station (50) comprises a treatment unit (100) outside said chamber (55) for treating a water-based washing liquid used in said washing station (50), wherein said liquid comprises some monomer or polymer detached from said plates (52) during their washing, wherein said treatment unit (100) comprises:
- a first tank (8) for collecting said washing liquid to a predetermined minimum filling level (L1), said monomer or said polymer surfacing in said first tank (8) after said liquid rests for a predetermined interval of time;
- a second tank (10) comprising a first inlet section (10A) arranged at a lower height (H1) than said minimum filling level (L1) of said first tank (8);
- a third tank (88) for collecting said washing liquid to a predetermined minimum filling level (L1*), said monomer or said polymer surfacing in said third tank (88) after said liquid rests for a predetermined interval of time, wherein said second tank (10) also comprises a second inlet section (10B) arranged at a lower height (H1*) than said minimum filling level (L1*) of said third tank (88);
- first barrier means (12), movable between a closing position, in which said first barrier means (12) prevent the communication between said first tank (8) and said second tank (10) and an opening position, by effect of which the first tank (8) and the second tank (10) become communicating so that at least said monomer or said polymer surfaced in said first tank (8) can overflow into said second tank (10) at said first inlet section (10A), and
- second barrier means (112), movable between a closing position, in which said second barrier means (112) prevent the communication between said third tank (88) and said second tank (10) and an opening position, by effect of which the third tank (88) and the second tank (10) become communicating so that at least said monomer or said polymer surfaced in said third tank (88) can overflow into said second tank (10) at said second inlet section (10B).

2. A washing station (50) according to claim 1, each of said tanks (8, 10, 88) comprises a bottom wall (81, 881, 101) and a side containing structure (82, 882, 102) defining an upper edge (102A, 102B) and wherein said second tank (10) is arranged in a position comprising between the first tank (8) and the second tank (88).

3. A washing station (50) according to claim 1 or 2, wherein said first barrier means (12) and/or said second barrier means (112) comprise at least one barrier which can be turned and translated, in reversible manner, between said closing position and said opening position.

4. A washing station (50) according to any one of the claims from 1 to 3, wherein said treatment unit (100) is provided with moving means (90) for moving, in reversible manner, said barrier means (12, 112) between said closing position and said opening position.

5. A washing station (50) according to any one of the claims from 1 to 4, wherein said treatment unit (100) comprises sensor means (9A, 9B) for detecting the liquid level in said first tank (8) and/or in said third tank (88).

6. A washing station (50) according to any one of the claims from 1 to 5, wherein said treatment unit (100) comprises a first washing liquid supplying line (401) and a second washing liquid supplying line (402), wherein said first supplying line (401) hydraulically connects said operative chamber (55) with said first tank (8) and said second supplying line (402) hydraulically connects said operative chamber (55) with said third tank (88), said treatment unit (100) comprising, for each of said supplying line (401, 402), a control valve (411, 412) switchable between an opening configuration and a closing configuration.

7. A washing station (50) according to any of the claims from 1 to 6, wherein the treatment unit (100) comprises a water hydraulic feeding line (91), which makes said first tank (8) and said third tank (8) connectable to a running water source (28), said feeding line (91) comprising a first terminal part (911) and a second terminal part (912) along which a first adjustment valve (14) and a second adjustment valve (114) are respectively installed.

8. A washing station (50) according to any of the claims 1 to 7, wherein it comprises a main hydraulic distribution line (350) to distribute washing liquid in the operative chamber (55), wherein said distribution line (350) comprises a first branch (351) and a second branch (352) respectively connected to said first tank (8) and to said third tank (88), wherein along each of said branches (351,352) of said distribution line (350) a control valve (601, 602) is provided to regulate the distribution of said washing line, said distribution line (350) connecting said first tank (8) and said third tank (88) to hydraulic terminals (188) placed into the operative chamber (55).

9. A washing station (50) according to any of the claims 1 to 8, wherein the washing station (50) comprises a water secondary distribution line (700) to distribute water up to hydraulic terminals (89) inside the chamber (55).

10. A washing station (50) according to claim 9 when depending on claim 7, wherein said water secondary distribution line (700) is hydraulically connected to said water hydraulic feeding line (91).

11. A washing station (50) according to any of the claims 8 to 10, wherein said washing station (50) comprises one or more tanks containing additive for the washing liquid and/or for the water introduced into the chamber (55), said washing station (50) further comprising one or more additive distribution lines (79A, 79B) for distributing the additive into the chamber (55).

12. A washing station (50) according to any of the claims 1 to 11, wherein said treatment unit (100) comprises a main discharge line (301) for discharging the liquid overflown into said second tank (10), said discharge line (301) comprising a first circulation pump (15) and a discharge valve (17) upstream of said first pump (15), said discharge line (301) being hydraulically connected to a distillation unit (200).

13. A washing station (50) according to claim 12, wherein said unit (100) comprises a first secondary discharge line (321), which connects said first tank (8) to said main discharge line (301), and a second secondary discharge line (322), which connects said third tank (88) to said main discharge line (301), wherein each of said secondary discharge line (321, 322) comprises a discharge valve (18, 118) which, in an opening condition, makes it possible to discharge the liquid contained in the corresponding tank (8, 88).

14. A washing station (50) according to any of the claims 1 to 13, wherein said washing station (50) comprises means for heating the washing liquid collected in said first tank (8) and in said third tank (88).

15. A washing station (50) according to any of the claims 1 to 14, wherein said first tank (8) and/or said third tank (88) comprises an internal separation wall (800) which separates the internal volume of the tank itself in two regions (8A-8B, 88A-88B), wherein said separation wall (800) defines, with a bottom wall (81, 811) of said tank (8, 88), a passage (850) which makes the two regions of said volume hydraulically connected so that the washing liquid may distribute in both the regions.

16. A method for treating water-based liquid used in a washing station (50) of flexographic plates (52), wherein said method includes the steps of:
A1) providing, outside an operative chamber (55) of the washing station (50), a first tank (8), a second tank (10) and a third tank (88), wherein the first tank (8) and the third tank (88) are provided for collecting the washing liquid used in the chamber (55) and wherein the second tank (10) comprises an inlet section (10A);
B1) arranging the second tank (10) with respect to the first tank (8) and to the third tank (88) so that its inlet section (10A) is at a lower height (H1) than a predetermined minimum filling level (L1, L1*) for the washing liquid in said first tank (8) and in said third tank (88);
C1) providing, between the first tank (8) and the second tank (10), first barrier means (12), and between the third tank (88) and the second tank (10), second barrier means (112), wherein said first barrier means (12) and said second barrier means (112) are configured to assume a closing position for which the corresponding tanks (8, 10 - 88, 10) are not communicating, and an opening position for which the liquid volume of said one the collecting tank (8, 88) comprised between the corresponding height (H1, H1*) of the corresponding inlet section (10A) and said minimum level (L1, L1*) can overflow into the second tank (10);
D1) filling one tank, among the first tank (8) and the third tank (88), with the washing liquid used in said operative chamber (55) to be treated to reach said predetermined minimum filling level (L1, L1*) wherein such filling is implemented with the corresponding barrier means (12, 112) in said closing position;
E1) keeping, at the end of said step D1), the washing liquid in a resting condition for a first predetermined interval of time, allowing the surfacing of the monomer or polymer contained in the liquid and the decanting of the water under the surfaced monomer or polymer;
F1) displacing said corresponding barrier means (12, 112) to said opening position to allow the overflowing of said liquid volume into said second tank 10.

## Patentansprüche

1. Waschstation (50) zum Waschen von Flexodruckplatten (52) mit einer wasserbasierten Waschflüssigkeit, wobei die Waschstation (50) eine Betriebs-kammer (55) und Bürstmittel zum Bürsten der Platten (52) umfasst, wobei die Station (50) eine Behandlungseinheit (100) außerhalb der Kammer (55) zum Behandeln einer wasserbasierten Waschflüssigkeit, die in der Waschstation (50) verwendet wird, umfasst, wobei die Flüssigkeit etwas Monomer oder Polymer umfasst, das von den Platten (52) während ihres Waschens abgelöst wird, wobei die Behandlungseinheit (100) umfasst:
- einen ersten Tank (8) zum Sammeln der Waschflüssigkeit bis zu einem vorbestimmten minimalen Füllstand (L1), wobei das Monomer oder das Polymer in dem ersten Tank (8) auftaucht, nachdem die Flüssigkeit für ein vorbestimmtes Zeitintervall ruht;
- einen zweiten Tank (10), der einen ersten Einlassabschnitt (10A) umfasst, der in einer geringeren Höhe (H1) als der minimale Füllstand (L1) des ersten Tanks (8) angeordnet ist;
- einen dritten Tank (88) zum Sammeln der Waschflüssigkeit bis zu einem vorbestimmten minimalen Füllstand (L1*), wobei das Monomer oder das Polymer in dem dritten Tank (88) auftaucht, nachdem die Flüssigkeit für ein vorbestimmtes Zeitintervall ruht, wobei der zweite Tank (10) auch einen zweiten Einlassabschnitt (10B) umfasst, der in einer geringeren Höhe (H1*) als der minimale Füllstand (L1*) des dritten Tanks (88) angeordnet ist;
- ein erstes Sperrmittel (12), das zwischen einer Schließposition, in der das erste Sperrmittel (12) die Verbindung zwischen dem ersten Tank (8) und dem zweiten Tank (10) verhindert, und einer Öffnungsposition bewegbar ist, durch die der erste Tank (8) und der zweite Tank (10) miteinander in Verbindung gebracht werden, sodass zumindest das Monomer oder das Polymer, das in dem ersten Tank (8) aufgetaucht ist, in den zweiten Tank (10) an dem ersten Einlassabschnitt (10A) überlaufen kann, und
- ein zweites Sperrmittel (112), das zwischen einer Schließposition, in der das zweite Sperrmittel (112) die Verbindung zwischen dem dritten Tank (88) und dem zweiten Tank (10) verhindert, und einer Öffnungsposition bewegbar ist, durch die der dritte Tank (88) und der zweite Tank (10) miteinander in Verbindung gebracht werden, sodass zumindest das Monomer oder das Polymer, das in dem dritten Tank (88) aufgetaucht ist, in den zweiten Tank (10) an dem zweiten Einlassabschnitt (10B) überlaufen kann.

2. Waschstation (50) nach Anspruch 1, wobei jeder der Tanks (8, 10, 88) eine untere Wand (81, 881, 101) und eine Seite mit einer Struktur (82, 882, 102), die eine obere Kante (102A, 102B) definiert, umfasst und wobei der zweite Tank (10) in einer Position angeordnet ist, die zwischen dem ersten Tank (8) und dem zweiten Tank (88) liegt.

3. Waschstation (50) nach Anspruch 1 oder 2, wobei das erste Sperrmittel (12) und/oder das zweite Sperrmittel (112) zumindest eine Sperre umfasst, die auf reversible Art und Weise zwischen der Schließposition und der Öffnungsposition gedreht und verschoben werden kann.

4. Waschstation (50) nach einem der Ansprüche 1 bis 3, wobei die Behandlungs-einheit (100) mit einem Bewegungsmittel (99) zum Bewegen des Sperrmittels (12, 112) auf reversible Art und Weise zwischen der Schließposition und der Öffnungsposition versehen ist.

5. Waschstation (50) nach einem der Ansprüche 1 bis 4, wobei die Behandlungs-einheit (100) ein Sensormittel (9A, 9B) zum Erfassen des Flüssigkeitsstands in dem ersten Tank (8) und/oder in dem dritten Tank (88) umfasst.

6. Waschstation (50) nach einem der Ansprüche 1 bis 5, wobei die Behandlungs-einheit (100) eine erste Waschflüssigkeits-Zufuhrleitung (401) und eine zweite Waschflüssigkeits-Zufuhrleitung (402) umfasst, wobei die erste Zufuhrleitung (401) die Betriebskammer (55) hydraulisch mit dem ersten Tank (8) verbindet und die zweite Zufuhrleitung (402) die Betriebskammer (55) hydraulisch mit dem dritten Tank (88) verbindet, wobei die Behandlungseinheit (100) für jede der Zufuhrleitungen (401, 402) ein Steuerventil (411, 412) umfasst, das zwischen einer Öffnungskonfiguration und einer Schließkonfiguration umschaltbar ist.

7. Waschstation (50) nach einem der Ansprüche 1 bis 6, wobei die Behandlungs-einheit (100) eine hydraulische Wasserzufuhrleitung (91) umfasst, die den ersten Tank (8) und den dritten Tank (8) mit einer Fließwasserquelle (28) verbindbar machen, wobei die Zufuhrleitung (91) einen ersten Anschlussteil (911) und einen zweiten Anschlussteil (912) umfasst, entlang derer jeweils ein erstes Einstellventil (14) und ein zweites Einstellventil (114) installiert sind.

8. Waschstation (50) nach einem der Ansprüche 1 bis 7, wobei sie eine hydraulische Hauptverteilungsleitung (350) zum Verteilen von Waschflüssigkeit in der Betriebskammer (55) umfasst, wobei die Verteilungsleitung (350) eine erste Verzweigung (351) und eine zweite Verzweigung (352) umfasst, die jeweils mit dem ersten Tank (8) und mit dem dritten Tank (88) verbunden sind, wobei entlang jeder der Verzweigungen (351, 352) der Verteilungsleitung (350) ein Steuerventil (601, 602) vorgesehen ist, um die Verteilung der Waschleitung zu regulieren, wobei die Verteilungsleitung (350) den ersten Tank (8) und den dritten Tank (88) mit hydraulischen Anschlüssen (188) verbindet, die in der Betriebskammer (55) platziert sind.

9. Waschstation (50) nach einem der Ansprüche 1 bis 8, wobei die Waschstation (50) eine sekundäre Wasserverteilungsleitung (700) zum Verteilen des Wassers bis zu den hydraulischen Anschlüssen (89) innerhalb der Kammer (55) umfasst.

10. Waschstation (50) nach Anspruch 9, wenn von Anspruch 7 abhängig, wobei die sekundäre Wasserverteilungsleitung (700) hydraulisch mit der hydraulischen Wasserzufuhrleitung (91) verbunden ist.

11. Waschstation (50) nach einem der Ansprüche 8 bis 10, wobei die Waschstation (50) einen oder mehrere Tanks umfasst, die ein Additiv für die Waschflüssigkeit und/oder für das in die Kammer (55) eingeführte Wasser aufweisen, wobei die Waschstation (50) weiter eine oder mehrere Additiv-Verteilungsleitungen (79A, 79B) zum Verteilen des Additivs in die Kammer (55) umfasst.

12. Waschstation (50) nach einem der Ansprüche 1 bis 11, wobei die Behandlungs-einheit (100) eine Hauptauslassleitung (301) zum Auslassen der in den zweiten Tank (10) übergelaufenen Flüssigkeit umfasst, wobei die Auslassleitung (301) eine erste Umwälzpumpe (15) und ein Auslassventil (17) stromaufwärts von der ersten Pumpe (15) umfasst, wobei die Auslassleitung (301) hydraulisch mit einer Destillationseinheit (200) verbunden ist.

13. Waschstation (50) nach Anspruch 12, wobei die Einheit (100) eine erste sekundäre Auslassleitung (321), die den ersten Tank (8) mit der Hauptauslassleitung (301) verbindet, und eine zweite sekundäre Auslassleitung (322) umfasst, die den dritten Tank (88) mit der Hauptauslassleitung (301) verbindet, wobei jede der sekundären Auslassleitungen (321, 322) ein Auslassventil (18, 118) umfasst, das es in einem Öffnungszustand ermöglicht, die in dem entsprechenden Tank (8, 88) enthaltene Flüssigkeit auszulassen.

14. Waschstation (50) nach einem der Ansprüche 1 bis 13, wobei die Waschstation (50) ein Mittel zum Heizen der in dem ersten Tank (8) und in dem dritten Tank (88) gesammelten Waschflüssigkeit umfasst.

15. Waschstation (50) nach einem der Ansprüche 1 bis 14, wobei der erste Tank (8) und/oder der dritte Tank (88) eine innere Trennwand (800) umfasst, die das Innenvolumen des Tanks selbst in zwei Bereiche (8A-8B, 88A-88B) trennt, wobei die Trennwand (800) mit einer unteren Wand (81, 811) des Tanks (8, 88) einen Durchgang (850) definiert, der die beiden Bereiche des Volumens hydraulisch verbindet, sodass sich die Waschflüssigkeit in den beiden Bereichen verteilen kann.

16. Verfahren zur Behandlung einer wasserbasierten Flüssigkeit, die in einer Waschstation (50) von Flexodruckplatten (52) verwendet wird, wobei das Verfahren die Schritte aufweist von:
A1) Bereitstellen eines ersten Tanks (8), eines zweiten Tanks (10) und eines dritten Tanks (88) außerhalb einer Betriebskammer (55) der Waschstation (50), wobei der erste Tank (8) und der dritte Tank (88) zum Sammeln der in der Kammer (55) verwendeten Waschflüssigkeit vorgesehen sind und wobei der zweite Tank (10) einen Einlassabschnitt (10A) umfasst;
B1) Anordnen des zweiten Tanks (10) in Bezug auf den ersten Tank (8) und den dritten Tank (88), sodass sein Einlassabschnitt (10A) in einer geringeren Höhe (H1) als ein vorbestimmter minimaler Füllstand (L1, L1*) für die Waschflüssigkeit in dem ersten Tank (8) und in dem dritten Tank (88) liegt;
C1) Bereitstellen eines ersten Sperrmittels (12) zwischen dem ersten Tank (8) und dem zweiten Tank (10) und eines zweiten Sperrmittels (112) zwischen dem dritten Tank (88) und dem zweiten Tank (10), wobei das erste Sperrmittel (12) und das zweite Sperrmittel (112) konfiguriert sind, um eine Schließposition, für die die entsprechenden Tanks (8, 10 - 88, 10) nicht in Verbindung stehen, und eine Öffnungsposition einzunehmen, für die das Flüssigkeitsvolumen des einen Sammeltanks (8, 88), der zwischen der entsprechenden Höhe (H1, H1*) des entsprechenden Einlassabschnitts (10A) und dem minimalen Stand (L1, L1*) liegt, in den zweiten Tank (10) überlaufen kann;
D1) Füllen eines Tanks unter dem ersten Tank (8) und dem dritten Tank (88) mit der Waschflüssigkeit, die in der Betriebskammer (55) verwendet wird, um behandelt zu werden, um den vorbestimmten minimalen Füllstand (L1, L1*) zu erreichen, wobei ein solches Füllen mit dem entsprechenden Sperrmittel (12, 112) in der Schließposition durchgeführt wird;
E1) Halten der Waschflüssigkeit am Ende des Schrittes D1) in einem Ruhezustand für ein erstes vorbestimmtes Zeitintervall, wodurch das Auftauchen des in der Flüssigkeit enthaltenen Monomers oder Polymers und das Dekantieren des Wassers unter dem aufgetauchten Monomer oder Polymer ermöglicht wird;
F1) Verschieben des entsprechenden Sperrmittels (12, 112) in die Öffnungsposition, um das Überlaufen des Flüssigkeitsvolumens in den zweiten Tank 10 zu ermöglichen.

## Revendications

1. Poste de lavage (50) pour laver des plaques flexographiques (52) avec un liquide de lavage à base d'eau, dans lequel ledit poste de lavage (50) comprend une chambre fonctionnelle (55) et des moyens de brossage pour brosser lesdites plaques (52), dans lequel ledit poste (50) comprend une unité de traitement (100) à l'extérieur de ladite chambre (55) pour traiter un liquide de lavage à base d'eau utilisé dans ledit poste de lavage (50), dans lequel ledit liquide comprend un certain monomère ou polymère détaché desdites plaques (52) pendant leur lavage, dans lequel ladite unité de traitement (100) comprend :
- un premier réservoir (8) pour collecter ledit liquide de lavage à un niveau de remplissage minimal prédéterminé (L1), ledit monomère ou ledit polymère émergeant dans ledit premier réservoir (8) après que ledit liquide reste pendant un intervalle de temps prédéterminé ;
- un deuxième réservoir (10) comprenant une première section d'entrée (10A) agencée à une hauteur plus basse (H1) que ledit niveau de remplissage minimal (L1) dudit premier réservoir (8) ;
- un troisième réservoir (88) pour collecter ledit liquide de lavage à un niveau de remplissage minimal prédéterminé (L1*), ledit monomère ou ledit polymère émergeant dans ledit troisième réservoir (88) après que ledit liquide reste pendant un intervalle de temps prédéterminé, dans lequel ledit deuxième réservoir (10) comprend également une seconde section d'entrée (10B) agencée à une hauteur plus basse (H1*) que ledit niveau de remplissage minimal (L1*) dudit troisième réservoir (88) ;
- des premiers moyens formant barrière (12), mobiles entre une position de fermeture, dans laquelle lesdits premiers moyens formant barrière (12) empêchent la communication entre ledit premier réservoir (8) et ledit deuxième réservoir (10), et une position d'ouverture, par l'effet duquel le premier réservoir (8) et le deuxième réservoir (10) communiquent de telle sorte qu'au moins ledit monomère ou ledit polymère ayant émergé dans ledit premier réservoir (8) puisse déborder dans ledit deuxième réservoir (10) au niveau de ladite première section d'entrée (10A), et
- des seconds moyens formant barrière (112), mobiles entre une position de fermeture, dans laquelle lesdits seconds moyens formant barrière (112) empêchent la communication entre ledit troisième réservoir (88) et ledit deuxième réservoir (10), et une position d'ouverture, par l'effet duquel le troisième réservoir (88) et le deuxième réservoir (10) communiquent de telle sorte qu'au moins ledit monomère ou ledit polymère ayant émergé dans ledit troisième réservoir (88) puisse déborder dans ledit deuxième réservoir (10) au niveau de ladite seconde section d'entrée (10B).

2. Poste de lavage (50) selon la revendication 1, chacun desdits réservoirs (8, 10, 88) comprend une paroi inférieure (81, 881, 101) et une structure de confinement latérale (82, 882, 102) définissant un nord supérieur (102A, 102B) et dans lequel le deuxième réservoir (10) est agencé dans une position comprenant entre le premier réservoir (8) et le troisième réservoir (88).

3. Poste de lavage (50) selon la revendication 1 ou 2, dans lequel lesdits premiers moyens formant barrière (12) et/ou lesdits seconds moyens formant barrière (112) comprennent au moins une barrière qui peut être tournée et déplacée en translation, de manière réversible, entre ladite position de fermeture et ladite position d'ouverture.

4. Poste de lavage (50) selon l'une quelconque des revendications de 1 à 3, dans lequel ladite unité de traitement (100) est pourvue de moyens de déplacement (90) pour déplacer, de manière réversible, lesdits moyens formant barrière (12, 112) entre ladite position de fermeture et ladite position d'ouverture.

5. Poste de lavage (50) selon l'une quelconque des revendications 1 à 4, dans lequel ladite unité de traitement (100) comprend des moyens de capteur (9A, 9B) pour détecter le niveau de liquide dans ledit premier réservoir (8) et/ou dans ledit troisième réservoir (88).

6. Poste de lavage (50) selon l'une quelconque des revendications 1 à 5, dans lequel ladite unité de traitement (100) comprend une première conduite d'alimentation en liquide de lavage (401) et une seconde conduite d'alimentation en liquide de lavage (402), dans lequel ladite première conduite d'alimentation en liquide de lavage (401) relie de manière hydraulique ladite chambre fonctionnelle (55) au dit premier réservoir (8) et ladite seconde conduite d'alimentation en liquide de lavage (402) relie de manière hydraulique ladite chambre fonctionnelle (55) au dit troisième réservoir (88), ladite unité de traitement (100) comprenant, pour chacune desdites conduites d'alimentation (401, 402), une vanne de régulation (411, 412) pouvant être commutée entre une configuration d'ouverture et une configuration de fermeture.

7. Poste de lavage (50) selon l'une quelconque des revendications 1 à 6, dans lequel l'unité de traitement (100) comprend une conduite d'alimentation hydraulique en eau (91), qui permet au dit premier réservoir (8) et au dit troisième réservoir (88) de pouvoir être raccordés à une source d'eau courante (28), ladite conduite d'alimentation (91) comprenant une première partie de borne (911) et une seconde partie de borne (912) le long desquelles une première vanne de réglage (14) et une seconde vanne de réglage (114) sont respectivement installées.

8. Poste de lavage (50) selon l'une quelconque des revendications 1 à 7, dans lequel il comprend une conduite de distribution hydraulique principale (350) pour distribuer un liquide de lavage dans la chambre fonctionnelle (55), dans lequel ladite ligne de distribution (350) comprend une première branche (351) et une seconde branche (352), raccordées respectivement au dit premier réservoir (8) et au dit troisième réservoir (88), dans lequel, le long de chacune desdites branches (351, 352) de ladite conduite de distribution (350), une vanne de régulation (601, 602) est disposée pour réguler la distribution de ladite conduite de lavage, ladite conduite de distribution (350) raccordant ledit premier réservoir (8) et ledit troisième réservoir (88) à des bornes hydrauliques (188) placés dans la chambre fonctionnelle (55).

9. Poste de lavage (50) selon l'une quelconque des revendications 1 à 8, dans lequel le poste de lavage (50) comprend une conduite de distribution secondaire (700) pour distribuer de l'eau jusqu'aux bornes hydrauliques (89) à l'intérieur de la chambre (55).

10. Poste de lavage (50) selon la revendication 9 lorsqu'elle dépend de la revendication 7, dans lequel ladite conduite de distribution secondaire (700) est raccordée de manière hydraulique à ladite conduite d'alimentation hydraulique en eau (91).

11. Poste de lavage (50) selon l'une quelconque des revendications 8 à 10, dans lequel ledit poste de lavage (50) comprend un ou plusieurs réservoirs contenant un additif pour le liquide de lavage et/ou pour l'eau introduits dans la chambre (55), ledit poste de lavage (50) comprenant en outre une ou plusieurs conduites de distribution d'additif (79A, 79B) pour distribuer l'additif dans la chambre (55).

12. Poste de lavage (50) selon l'une quelconque des revendications 1 à 11, dans lequel ladite unité de traitement (100) comprend une conduite d'évacuation principale (301) pour évacuer le liquide débordant dans ledit deuxième réservoir (10), ladite conduite d'évacuation (301) comprenant une première pompe de circulation (15) et une vanne de refoulement (17) en amont de ladite pompe (15), ladite conduite d'évacuation (301) étant raccordée de manière hydraulique à une unité de distillation (200).

13. Poste de lavage (50) selon la revendication 12, dans lequel ladite unité (100) comprend une première conduite d'évacuation secondaire (321), qui raccorde ledit premier réservoir (8) à ladite conduite d'évacuation principale (301), et une seconde conduite d'évacuation secondaire (322), qui raccorde ledit troisième réservoir (88) à ladite conduite d'évacuation principale (301), dans lequel chacune desdites conduites d'évacuation secondaires (321, 322) comprend une vanne de refoulement (18, 118) qui, dans un état d'ouverture, permet d'évacuer le liquide contenu dans le réservoir correspondant (8, 88).

14. Poste de lavage (50) selon l'une quelconque des revendications 1 à 13, dans lequel ledit poste de lavage (50) comprend des moyens pour chauffer le liquide de lavage collecté dans ledit premier réservoir (8) et dans ledit troisième réservoir (88).

15. Poste de lavage (50) selon l'une quelconque des revendications 1 à 14, dans lequel ledit premier réservoir (8) et/ou ledit troisième réservoir (88) comprennent une paroi de séparation interne (800) qui sépare le volume interne du réservoir lui-même en deux régions (8A-8B, 88A-88B), dans lequel ladite paroi de séparation (800) définit, avec une paroi inférieure (81, 811) dudit réservoir (8, 88), un passage (850) qui permet de raccorder de manière hydraulique les deux régions dudit volume de telle sorte que le liquide de lavage puisse être distribué dans les deux régions.

16. Procédé pour traiter un liquide à base d'eau utilisé dans un poste de lavage (50) de plaques flexographiques (52), dans lequel ledit procédé comprend les étapes consistant :
A1) à fournir, à l'extérieur d'une chambre fonctionnelle (55) du poste de lavage (50), un premier réservoir (8), un deuxième réservoir (10) et un troisième réservoir (88), dans lequel le premier réservoir (8) et le troisième réservoir (88) sont fournis pour collecter le liquide de lavage utilisé dans la chambre (55) et dans lequel le deuxième réservoir (10) comprend une section d'entrée (10A) ;
B1) à agencer le deuxième réservoir (10) par rapport au premier réservoir (8) et au troisième réservoir (10) de telle sorte que sa section d'entrée (10A) se trouve à une hauteur plus basse (H1) qu'un niveau de remplissage minimal prédéterminé (L1, L1*) pour le liquide de lavage dans ledit premier réservoir (8) et dans ledit troisième réservoir (88) ;
C1) à fournir, entre le premier réservoir (8) et le deuxième réservoir (10), des premiers moyens formant barrière (12), et entre le troisième réservoir (88) et le deuxième réservoir (10), des seconds moyens formant barrière (112), dans lequel lesdits premiers moyens formant barrière (12) et lesdits seconds moyens formant barrière (112) sont configurés pour adopter une position de fermeture pour laquelle les réservoirs correspondants (8, 10 - 88, 10) ne communiquent pas, et une position d'ouverture pour laquelle le volume de liquide de l'un dit réservoirs des réservoirs de collecte (8, 88) inclus entre la hauteur correspondante (H1, H1*) de la section d'entrée correspondante (10A) et ledit niveau minimal (L1, L1*) peut déborder dans le deuxième réservoir (10) ;
D1) à remplir un réservoir, parmi le premier réservoir (8) et le troisième réservoir (88),
avec le liquide de lavage utilisé dans ladite chambre fonctionnelle (55) à traiter pour atteindre ledit niveau de remplissage minimal prédéterminé (L1, L1*), dans lequel un tel remplissage est mis en œuvre avec les moyens formant barrière correspondants (12, 112) dans ladite position de fermeture ;
E1) à garder, à la fin de ladite étape D1), le liquide de lavage dans un état restant pendant un premier intervalle de temps prédéterminé, permettant l'émersion du monomère ou du polymère contenu dans le liquide et le décantation de l'eau sous le monomère ou le polymère émergé ;
F1) à déplacer lesdits moyens formant barrière correspondants (12, 112) jusqu'à ladite position d'ouverture pour permettre le débordement dudit volume de liquide dans ledit deuxième réservoir (10).
